Europäisches Patentamt

European Patent Office

Office européen des brevets

(19)

(11) Veröffentlichungsnummer : **0 548 127 B1**

(12) **EUROPÄISCHE PATENTSCHRIFT**

(45) Veröffentlichungstag der Patentschrift :
**01.03.95 Patentblatt 95/09**

(51) Int. Cl.$^6$ : **G06F 15/80**

(21) Anmeldenummer : **91915650.5**

(22) Anmeldetag : **29.08.91**

(86) Internationale Anmeldenummer :
**PCT/EP91/01641**

(87) Internationale Veröffentlichungsnummer :
**WO 92/04687 19.03.92 Gazette 92/07**

(54) **Neuronales Netzwerk und Schaltungsanordnung zur Bool'schen Realisierung neuronaler Netze vom ADALINE-Typ.**

(30) Priorität : **11.09.90 EP 90117475**

(43) Veröffentlichungstag der Anmeldung :
**30.06.93 Patentblatt 93/26**

(45) Bekanntmachung des Hinweises auf die
Patenterteilung :
**01.03.95 Patentblatt 95/09**

(84) Benannte Vertragsstaaten :
**DE FR GB IT**

(56) Entgegenhaltungen :
**ELECTRONICS LETTERS, Bd. 25, Nr. 10, 11-05-1989,Seiten 657-659; R. AL-Alawi et al.: "Functionality of multilayer boolean neural networks"**

(56) Entgegenhaltungen :
**IEEE Transactions on Acoustics, Speech and Signal Processing, Bd. 36, Nr. 7, Juli 1988,Seiten 1109-1118; B. Widrow et al.: "Layered neural nets for pattern recognition"**
**IEEE PACIFIC RIM CONFERENCE ON COMMUNICATIONS, COMPUTERS AND SIGNAL PROCESSING, 1. Juni 1989, New York, US, Seiten 509-512; L. Atlas et al.: "Multi-scale dynamic neural net architectures"**

(73) Patentinhaber : **SIEMENS AKTIENGESELLSCHAFT Wittelsbacherplatz 2 D-80333 München (DE)**

(72) Erfinder : **STROBACH, Peter Josef-Maria-Lutz-Strasse 32 D-8000 München 83 (DE)**

EP 0 548 127 B1

EP 0 548 127 B1

## Beschreibung

In vielen Bereichen der adaptiven Signalverarbeitung und Mustererkennung gewinnen neuronale Netzwerke zunehmend an Bedeutung (D.E. Rumelhart, J.L. McClelland, Parallel Distributed Processing, Vols. I and II, MIT-Press, Cambridge, MA, 1986). Es gibt unterschiedliche Typen neuronaler Netze, welche an unterschiedliche Aufgabenstellungen angepaßt sind. In der Mustererkennung werden bevorzugt rein vorwärts gekoppelte neuronale Netzwerke vom ADALINE-Typ (B.Widrow, R.G.Winter, P.A. Baxter, "Layered neural nets for pattern recognition", IEEE Trans. on ASSP, Vol. ASSP-36, No. 7, p. 1109-1118, 1988) eingesetzt.

Das Basiselement des ADALINE-Netzwerkes ist das "adaptive lineare Neuron" (ADALINE). Hierunter versteht man einen linearen Kombinierer, dem ein Vorzeichenentscheider nachgeschaltet ist. Der lineare Kombinierer erzeugt eine gewichtete Summe aus N-Eingangssignalen, deren Vorzeichen durch den Vorzeichenentscheider (einstufiger Quantisierer) ermittelt und als Ausgangssignal des ADALINE ausgegeben wird (P.Strobach, "A neural network with Boolean Output Layer", Proc. IEEE Int.Conf. on ASSP, Albuquerque, NM, April 1990).

Durch Hintereinanderschaltung solcher ADALINE Neuronen erhält man ADALINE Netzwerke, welche - in Abhängigkeit von den Werten der Gewichtsfaktoren der linearen Kombinierer - den an die freien Eingangsknoten des Netzwerkes angelegten Signalen binäre Ausgangssignale zuordnen.

Diese binären Ausgangssignale werden als Klassifizierung der Eingangssignale interpretiert. Dabei können die Eingangssignale binär, diskret mehrwertig, oder einem Intervall kontinuierlicher Werte entnommen sein. Um eine gewünschte Klassifizierung der Eingangssignale durch das neuronale Netz einstellen zu können, müssen die Werte der Gewichtsfaktoren quasi kontinuierlich veränderbar sein. In einem Trainingsverfahren zur Ermittlung der gesuchten Werte der Gewichtsfaktoren werden diese mit dem Ziel der Minimierung eines Maßes für die Abweichung zwischen den tatsächlichen Ausgangssignalen des Netzes und den gewünschten Ausgangssignalen (Soll-Antworten) für einen Satz von Trainingsdaten solange abgeändert, bis die tatsächlichen Antworten mit den Sollantworten hinreichend genau übereinstimmen.

Aus diesem Grund sind alle bekannten Realisierungen neuronaler Netze entweder mit Hilfe von Analogschaltungen (P.Müller et al, "A Programmable Analog Neural Computer and Simulator", Adv.Neural Inform. Proc. Systems 1, D.S. Touretzky (ed.), Morgan Kaufmann Publ., San Mateo, CA, 1989, pp. 712 - 719 oder mit Hilfe von Digitalschaltungen mit hoher Wortbreite (N.M. Allinson, "Digital Realisation of Self-Organizing Maps", Adv. Neural Inform. Proc. Systems 1, D.S. Touretzky (ed.), Morgan Kaufmann Publ., San Mateo, CA, 1989, pp. 728 - 738) ausgeführt. Bei letzteren werden die kontinuierlichen Eingangssignale und Gewichtsfaktoren durch eine große Zahl diskreter Stufen approximiert, welche durch binäre Variablen, großer Wortbreite dargestellt werden. Die linearen Kombinierer erfordern in allen bekannten Realisierungen von ADALINE-Netzen einen sehr hohen schaltungstechnischen Aufwand, welcher der Hardware-Realisierung neuronaler Netze mit größeren Zahlen von Neuronen im Wege steht.

Für die meisten Anwendungen neuronaler Netze in der Mustererkennung werden mehrlagige Netze benötigt (Rumelhart 1986). Die Neuronen der ersten Lage sind dabei unmittelbar mit den Eingangsknoten verbunden. Die Ausgangssignale der Neuronen der ersten Lage bilden die Eingangssignale der Neuronen der zweiten Lage. Allgemein bilden die Ausgangssignale der Neuronen einer Lage die Eingangssignale der Neuronen der folgenden Lage. Da die Ausgangssignale aller Neuronen binär sind, sind auch die Eingangssignale der Neuronen aller höheren Lagen zwangsläufig binär. Das Teilnetz der höheren Lagen "sieht" also auch dann stets binäre Eingangssignale, wenn die eigentlichen Eingangssignale des gesamten Netzes andere als nur binäre Werte annehmen können. Das Teilnetz der höheren Lagen wird deshalb auch als "Boolean Output Layer" bezeichnet. Die Erfindung hat ein Verfahren und eine Anordnung zur Realisierung neuronaler Netze vom ADALINE-Typ mit Boole'schen Eingangssignalen unter ausschließlicher Verwendung Boole'scher Funktionen und digitaler Schaltungen zum Gegenstand.

Dabei kann das ADALINE-Netz der "Boolean Output Layer" eines komplexeren Netzes mit diskreten mehrwertigen oder kontinuierlichen Eingangssignalen sein. Es gibt aber auch Anwendungen, bei denen die Eingangssignale primär binäre Werte aufweisen. In diesem Fall kann das gesamte Netz durch reine Digitalschaltungen exakt realisiert werden, wogegen im allgemeinen nur der "Boolean Output layer", der allerdings regelmäßig den weitaus größten Teil des Netzes ausmacht, durch rein digitale Schaltungen zu verwirklichen ist.

Die Erfindung umfaßt
- ein neuronales Netzwerk vom ADALINE-Typ, dessen Eingänge Boole'sche Variable sind, realisiert durch Boole'sche Funktionen mit Merkmalen nach Anspruch 1;
- eine Schaltungsanordnung zur Realisierung neuronaler Netzwerke vom ADALINE-Typ mit Merkmalen nach Anspruch 2;
- ein Verfahren zum Training der Schaltungsanordnung mit Merkmalen nach Anspruch 5.

Weiterbildungen der Erfindurg ergeben sich aus den Unteransprüchen.

2

Das Verfahren, wodurch das neuronale Netzwerk nach Anspruch 1 entsteht, ermöglicht die Realisierung neuronaler Netzwerke vom ADALINE-Typ, deren Eingänge Boole'sche (also binäre) Variable sind, durch Boole'sche Funktionen. Dabei werden für beliebige mögliche Werte der Gewichtsfaktoren jeweils die Boole'schen Funktionen ermittelt, die das ADALINE-Netz realisieren. Zu diesem Zweck werden die primär im ADALINE-Netz vorhandenen Neuronen (im folgenden als erste Neuronen bezeichnet) in binäre Bäume aus adaptiven linearen Kombinierern entwickelt. Damit eine Entwicklung in binäre Bäume durchführbar ist, werden die Zahlen der Eingänge der ersten Neuronen als ganzzahlige Zweier-Potenzen angenommen. Die allgemeine Anwendbarkeit des Verfahrens wird hierdurch nicht berührt, da jedes Neuron mit einer Zahl von Eingängen, die keine Potenz von zwei ist, um soviele Eingänge mit Gewichtsfaktoren Null erweitert werden kann, daß die Zahl der Eingänge schließlich eine Potenz von zwei ist.

Hat ein Neuron des ADALINE-Netzes z.B. $2^n$ binäre Eingänge, dann wird dieses Neuron durch einen äquivalenten Baum aus $2^n-2$ adaptiven linearen Kombinierern mit jeweils zwei Eingängen ersetzt, dem ein Neuron mit zwei Eingängen (im folgenden als zweites Neuron bezeichnet) nachgeschaltet wird.

Im ersten Schritt des Verfahrens werden weiterhin zwischen der Ausgängen aller im ersten Schritt erhaltenen adaptiven linearen Kombinierer und den Eingängen der ihnen nachgeschalteten adaptiven linearen Kombinierer binäre Quantisierer (d.h. Vorzeichenentscheider) eingefügt, wodurch die adaptiven linearen Kombinierer in zweite Neuronen umgewandelt werden.

Im zweiten Schritt des Verfahrens werden die Gewichte derjenigen zweiten Neuronen, welche den Blättern der binären Bäume entsprechen, mit den Gewichten der ersten Neuronen übereinstimmend gewählt. Danach werden im vierten Schritt dieses Verfahrens die Gewichte der übrigen zweiten Neuronen auf den Zweigen der binären Bäume, denen die binären Quantisierer vorgeschaltet sind, gleich den Absolutbeträgen der Ausgangsgrößen der diesen Quantisierern vorgeschalteten adaptiven linearen Kombinierern gesetzt. Schließlich werden im letzten Schritt des Verfahrens sämtliche $2^n-1$ zweite Neuronen in Abhängigkeit von ihren Eingangsgewichten durch die ihnen entsprechenden Boole'schen Funktionen zweier Variabler ersetzt.

Die Schaltungsanordnung nach Anspruch 2 stellt eine rein digitale Realisierung neuronaler Netze vom ADALINE-Typ dar, bei der jedes im Anspruch 1 beschriebene zweite Neuron durch eine digitale Basisschaltung realisiert wird. Die digitale Basisschaltung ist in der Lage, sämtliche Boole'schen Funktionen, welche ein ADALINE mit zwei binären Eingangssignalen für beliebige Werte seiner zwei Gewichtsfaktoren realisieren kann, zu berechnen.

Zur Erfindung gehört ferner ein Verfahren mit Merkmalen nach Anspruch 5 zum Training dieser Schaltungsanordnung. Das Trainingsverfahren steht im Gegensatz zu bekannten Trainingsverfahren für ADALINE-Netze in keiner Beziehung zu den kontinuierlich veränderlichen Gewichten des ursprünglichen neuronalen Netzes, sondern verändert die Registerinhalte der Basisschaltungen in zufälliger Weise mit dem Ziel eine Kostenfunktion zu minimieren.

Figur 1 zeigt den Signalflußplan eines ADALINE-Neurons mit zwei Eingängen.

Figur 2 zeigt die Partitionierung eines mehrlagigen ADALINE-Netzwerkes in den Hidden-Layer (HL) und den Boolean Output-Layer (BOL).

Figur 3 zeigt die Zusammensetzung eines allgemeinen ADALINE-Neztwerkes aus Hidden-Layer und Boolean-Output Layer.

Figur 4 zeigt die möglichen Klassifikationen der Eingangsmuster eines ADALINE-Neurons mit zwei binären Eingängen, dargestellt als Eckpunkte des binären 2-Würfels, separiert durch eine Hyperebene in Abhängigkeit von den Eingangsgewichten.

Figur 5 zeigt den Signalflußplan eines ADALINE-Neurons mit acht Eingängen.

Figur 6 zeigt die Entwicklung eines ADALINE-Neurons mit acht Eingängen in einen binären Baum aus adaptiven linearen Kombinierern.

Figur 7 zeigt den zu einem ersten ADALINE-Neuron mit acht Eingängen äquivalenten binären Baum aus sieben binären zweiten ADALINE-Neuronen.

Figur 8 zeigt den zu einem ADALINE-Neuron mit acht Eingängen äquivalenten binären Baum aus digitalen Basisschaltungen.

Figur 9 zeigt eine bevorzugte Ausführung der digitalen Basisschaltung.

Figur 10 zeigt die Schaltungsanordnung zur digitalen Realisierung eines ADALINE-Neurons mit acht Eingängen.

Figur 11 zeigt einen Signalflußplan zur Berechnung der Kostenfunktion.

Figur 12 zeigt eine bevorzugte Ausführung einer Anordnung zur Durchführung des Trainingsverfahrens.

Im folgenden wird die Erfindung anhand eines bevorzugten Ausführungsbeispiels mit Hilfe der Figuren erläutert.

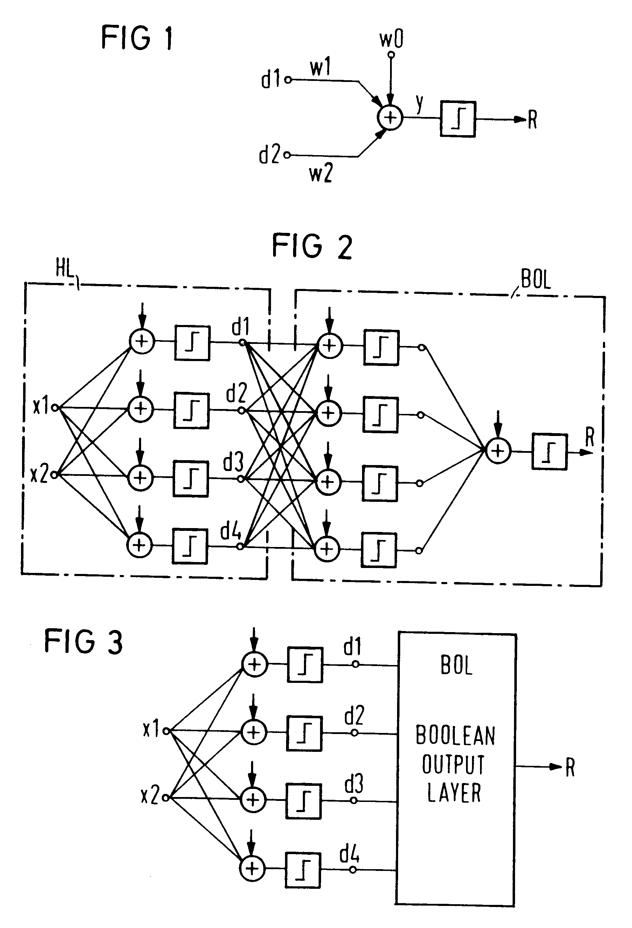

Zur Beschreibung dieses bevorzugten Ausführungsbeispieles wird ein dreilagiges ADALINE-Netzwerk mit N-Eingängen und einem Ausgang betrachtet. Der allgemeinere Fall mehrerer Ausgänge ergibt sich ohne weitere Überlegungen aus diesem Spezialfall. Es sei ferner angenommen, daß die N-Eingänge des betrachteten ADALINE-Netzwerkes nicht nur binäre, sondern mehrstufige oder kontinuierliche Werte annehmen können. Da die Ausgangssignale d1, ... , d4 (Figur 2) der ersten Lage (HL) stets auf binäre Werte beschränkt sind, und zwar auch dann, wenn die Eingangssignale x1, x2 (Figur 2) mehrstufig oder kontinuierlich sind, bilden die beiden oberen Lagen ein ADALINE-Netzwerk mit binären Eingängen, den Boolean-Output Layer (BOL), der in dem betrachteten Fall einen binären Ausgang R (Figur 2 bzw. 3) hat.

Die Erfindung hat ausschließlich den Boolean Output Layer (BOL) zum Gegenstand, der in all jenen Fällen mit dem gesamten ADALINE-Netz identisch ist, in denen die N-Eingänge auf binäre (Boole'sche) Werte beschränkt sind.

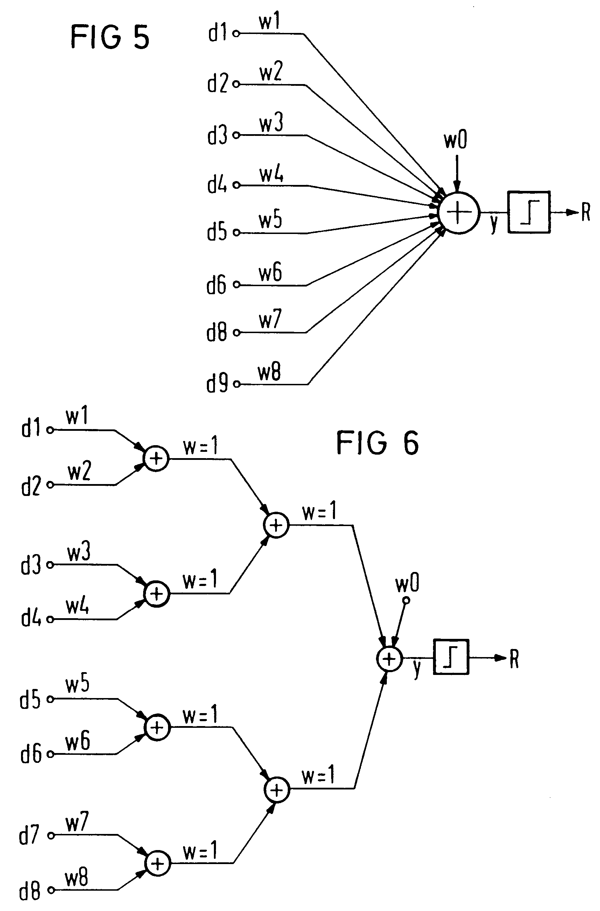

Die Figuren 1 bzw. 5 zeigen zwei ADALINE-Neuronen mit zwei bzw. acht Eingängen und den Gewichten w1, w2 bzw. w1, .... w8. Der mit w0 bezeichnete nullte Eingang ist zu einer Verschiebung der Vorzeichenentscheidung äquivalent. Einem ADALINE-Neuron mit N-Eingängen können stets beliebig viele mit null belegte Eingänge hinzugefügt werden, ohne an seiner Funktion etwas zu ändern. Dieser Umstand ermöglicht es, ohne Einschränkung der Allgemeinheit anzunehmen, jedes im Netzwerk vorhandene Neuron habe eine Zahl von Eingängen, die eine ganzzahlige Potenz von 2 ist.

Der erste Schritt des Verfahrens, wodurch das neuronale Netz nach Anspruch 1 entsteht, besteht darin, jedes erste Neuron mit z.B. $2^n$ Eingängen in einen binären Baum aus $2^n\text{-}2$ adaptiven linearen Kombinierern zu entwickeln, an dessen Wurzel ein zweites Neuron mit zwei Eingängen einen binären Ausgang R berechnet. Figur 6 zeigt die Entwicklung des in Figur 5 gezeigten ersten Neurons in einen binären Baum aus adaptiven linearen Kombinierern. Figur 1 zeigt ein zweites Neuron, wie es z.B. an der Wurzel des binären Baumes in Figur 6 zu sehen ist.

Zur allgemeinen Durchführung dieses ersten Verfahrensschrittes werden die $2^n$ binären Eingänge jedes ersten Neurons zu Paaren zusammengefaßt. Jedes Paar von Eingängen wird mit Hilfe eines adaptiven linearen Kombinierers summiert. Die $2^{n-1}$ Summensignale werden paarweise mit Gewicht 1 linear kombiniert, also addiert. Diese paarweise Addition von Summensignalen wird fortgesetzt, bis nur noch zwei Summensignale vorhanden sind. Diese werden dem Addierer des ursprünglich vorhandenen ersten Neurons zugeführt, oder, dazu äquivalent, den Eingängen eines zweiten Neurons zugeführt, dessen zwei Gewichtsfaktoren zunächst den Wert 1 annehmen. Der so entstandene binäre Baum aus adaptiven linearen Kombinierern und einem ADALINE-Neuron mit zwei Eingängen ist äquivalent dem ersten Neuron mit $2^n$ binären Eingängen.

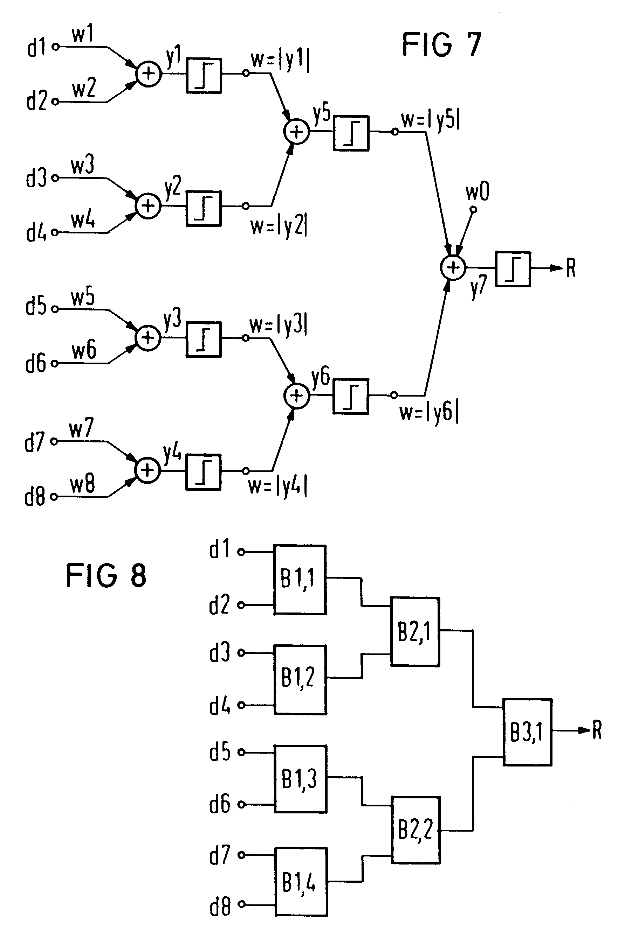

Im ersten Schritt des Verfahrens werden weiterhin die erhaltenen linearen Kombinierer in zweite Neuronen umgewandelt, indem zwischen den Ausgängen aller adaptiven linearen Kombinierer und den Eingängen der ihnen nachgeschalteten Kombinierer Vorzeichenentscheider (einstufige Quantisierer) eingefügt werden. Damit der so erhaltene binäre Baum aus zweiten Neuronen (Figur 7) weiterhin äquivalent zu dem ursprünglichen ersten Neuron ist, werden im zweiten Schritt des Verfahrens die Gewichte der zweiten Neuronen, die den Blättern des binären Baums entsprechen, mit den Gewichten des ersten Neurons übereinstimmend gewählt, und im dritten Schritt die Gewichte der übrigen zweiten Neuronen auf den Zweigen der binären Bäume mit den Absolutbeträgen der Ausgangsgrößen der ihnen vorgeschalteten Kombinierer gleichgesetzt (Figur 7).

Der so erhaltene binäre Baum aus zweiten Neuronen, den Figur 7 für den Fall eines ersten Neurons mit acht Eingängen zeigt, ist wieder äquivalent dem ersten Neuron des ursprünglichen ADALINE-Netzwerkes. Auf diese Weise lassen sich beliebige ADALINE-Netzwerke in Netzwerke aus ADALINE's mit nur zwei Eingängen (Figur 1) umwandeln. ADALINE's mit nur zwei binären Eingängen (zweite Neuronen) haben gegenüber allgemeinen ADALINE's den Vorzug, daß ihre Eigenschaften in sehr übersichtlicher Weise durch einen Satz von Boole'schen Funktionen beschrieben werden können. Das ADALINE in Figur 1 wird durch die Gleichungen

$$(1) \qquad y = w0 + w1\, d1 + w2\, d2$$

$$(2) \qquad R = SGN(y) = \begin{cases} 1 \text{ falls } y \geqslant 0 \\ -1 \text{ falls } y < 0 \end{cases}$$

beschrieben. Für d1, d2 $\in\{-1,+1\}$ gibt es in Abhängigkeit von den Werten der Gewichte w0, w1 und w2 14 mögliche von 16 denkbaren Boole'schen Funktionen, die durch die Gleichungen (1) und (2) realisierbar sind. Die nicht realisierbaren Funktionen sind die Exklusiv-Oder Verknüpfung und die negierte Exklusiv-Oder-Verknüpfung.

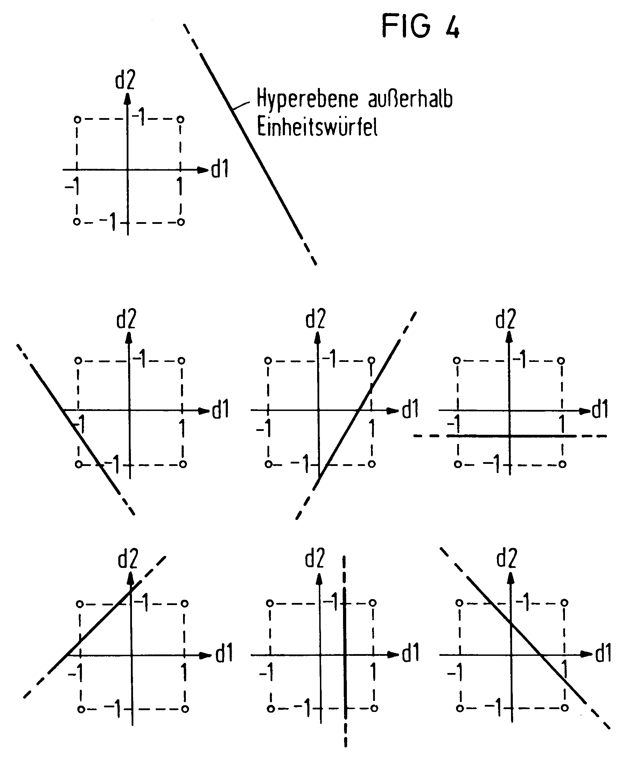

Figur 4 zeigt sieben Diagramme, welche man durch Spiegelung der Hyperebene am Koordinatenursprung zu 14 Diagrammen erweitern kann. Diese 14 Diagramme entsprechen den 14 mit Hilfe eines zweiten Neurons (ADALINE mit zwei binären Eingängen) realisierbaren Boole'schen Funktionen. Die Boole'schen Funktionen erhält man aus den Diagrammen, indem man den Punkten (Eingangswerten) auf der einen Seite der Hyperebene den Ausgangswert 1 für "wahr" und den Punkten auf der anderen Seite der Hyperebene den Ausgangswert -1 für "falsch" zuordnet.

Der vierte und damit letzte Schritt des Verfahrens besteht nun darin, die im dritten Schritt erhaltenen zweiten Neuronen in Abhängigkeit von den Werten ihrer Gewichtsfaktoren durch die ihnen entsprechenden Boole'schen Funktionen zu ersetzen. Dies geschieht vorzugsweise dadurch, daß für jedes zweite Neuron nach Maßgabe der Werte ihrer Gewichtsfaktoren das ihm entsprechende der 14 Diagramme nach Figur 4 (bzw. nach den durch Spiegelung der Hyperebene am Koordinatenursprung aus den Diagrammen der Figur 4 erhaltenen Diagrammen) ermittelt wird. Dazu ermittelt man die Achsenabschnitte d1, d2 aus der Gleichung

$$(3) \qquad y = w1\, d1 + w2\, d2 + w0 = 0$$

für gegebene Gewichtsfaktoren w0, w1 und w2 und erhält die gesuchte Boole'sche Funktion für jedes zweite Neuron.

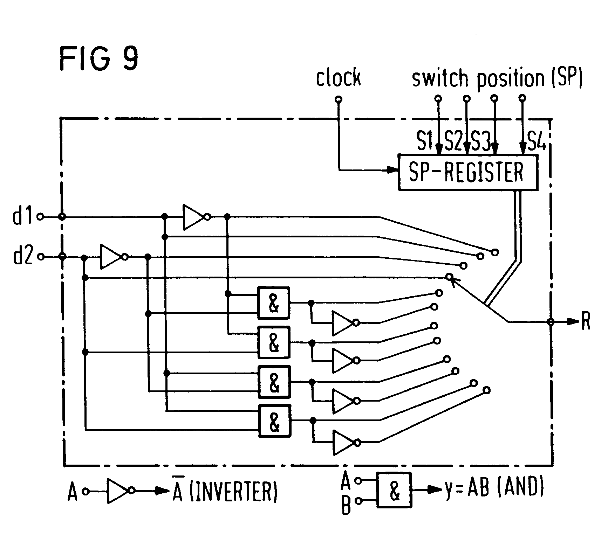

Dieses Verfahren kann somit als Entwurfsverfahren für eine Realisierung eines ADALINE-Netzwerkes durch digitale Schaltungen auf der Logikebene angesehen werden. Der tatsächliche Aufbau einer digitalen Schaltung, die das ADALINE-Netz in Hardware realisiert, wird nun vorzugsweise unter Verwendung einer universellen Basisschaltung durchgeführt, wie sie Figur 9 zeigt. Aus den Eingangssignalen d1, d2 der Basisschaltung werden vorzugsweise mit Hilfe von AND-Gattern und Invertern die 12 nicht trivialen Boole'schen Funktionen (zwei der 14 Boole'schen Funktionen sind nämlich konstant "wahr" bzw. konstant "falsch") erzeugt, die ein zweites Neuron - je nach den Werten seiner Gewichtsfaktoren - berechnen kann. Die jeweils benötigte Boole'sche Funktion wird dabei über einen Demultiplexer, der mit Hilfe eines SP-Registers gesteuert wird, ausgewählt. Der Inhalt des Registers (SP), welches durch einen Clock-Eingang aktivierbar ist, bestimmt also die Funktion der Basisschaltung und damit die Ausgangswerte R. Damit treten die Inhalte des Registers an die Stelle der Gewichtsfaktoren w1, ... wn, ... des ADALINE-Netzwerkes.

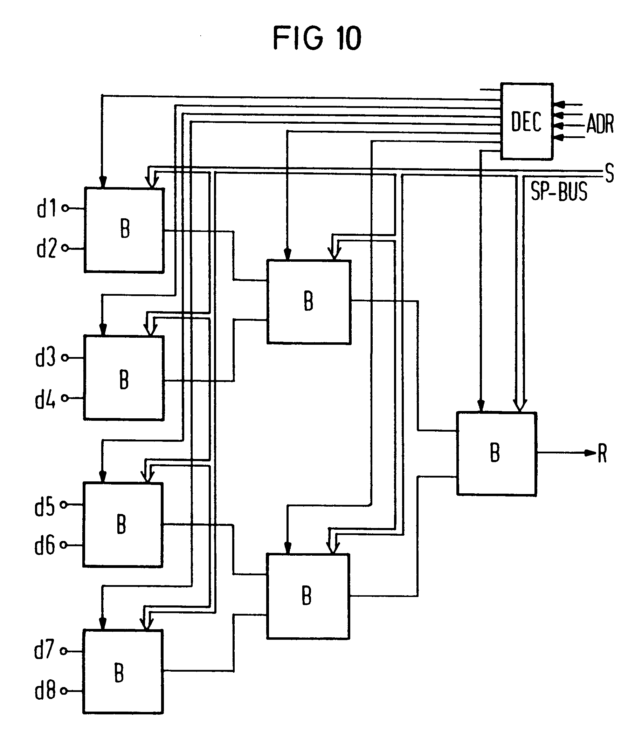

Figur 10 zeigt ein bevorzugtes Ausführungsbeispiel der Schaltungsanordnung zur Realisierung neuronaler Netzwerke vom ADALINE-Typ, bei dem die Register der Basiszellen mit einem SP-Bus S verbunden sind, über den die Registerinhalte in die SP-Register geschrieben werden können. Das jeweils zu beschreibende Register wird mit Hilfe eines Adreßdecoders DEC, der die Basisschaltungsadressen ADR decodiert, über die Clockeingänge der Basisschaltungen ausgewählt (aktiviert).

Diese Schaltungsanordnung zur Realisierung neuronaler Netzwerke vom ADALINE-Typ kann nicht unter Verwendung herkömmlicher Trainingsverfahren für neuronale Netze trainiert werden, da die Variablen solcher herkömmlichen Trainingsverfahren kontinuierliche oder in feinen Stufen veränderliche diskrete Gewichtsfaktoren sind, welche in der Schaltungsanordnung zur Realisierung neuronaler Netzwerke vom ADALINE-Typ keine Entsprechung haben.

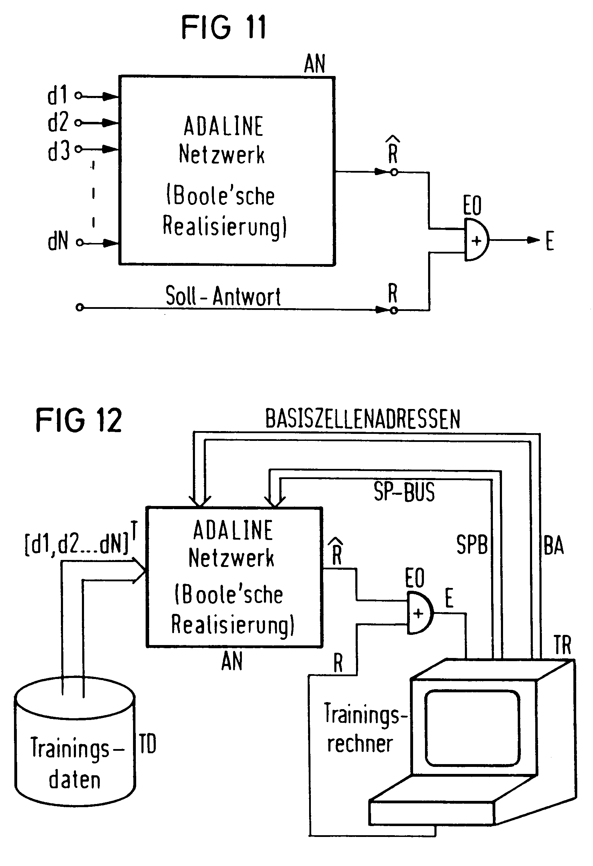

Das erfindungsgemäße Trainingsverfahren basiert deshalb auf einer Veränderung der Registerinhalte der Basisschaltungen, durch welche mit Hilfe des in der Basisschaltung enthaltenen Demultiplexers die jeweils benötigte Boole'sche Funktion aus der Menge der mit Hilfe der Basisschaltung berechneten Boole'schen Funktionen ausgewählt wird. Der Betrieb der Schaltungsanordnung im Rahmen des Trainingsverfahrens wird mit Hilfe von Figur 11 verdeutlicht. An die Eingänge d1 bis dn der Schaltungsanordnung werden Trainingsdaten angelegt. In Abhängigkeit von der in den SP-Registern der Basiszellen gespeicherten Information generiert das Netzwerk an seinem Ausgang eine Entscheidung $\hat{R}$. Diese Entscheidung wird mit einer gewünschten Entscheidung (Sollantwort R) verglichen. Der Vergleich erfolgt über die EXOR-Funktion. Diese Operation wird für alle Trainingsvektoren (Mustervektoren) des Trainingsdatensatzes durchgeführt. Auf diese Weise kann man eine Kostenfunktion E angeben, welche das Maß der Anpassung des Netzes an die Trainingsdaten beschreibt. Solch eine Kostenfunktion ist vorzugsweise die Summe der Werte am EXOR-Ausgang für alle Trainingsdaten:

$$(4) \qquad E = \sum_{K=1}^{M} EXOR\left(\hat{R}_K, R_K\right)$$

Dabei ist M die Anzahl der Trainingsvektoren. Die Kostenfunktion E beschreibt das Verhalten des Netzwerkes für den gesamten Satz von Trainingsdaten bestehend aus M-binären Trainingsvektoren mit jeweils N Komponenten. Das Netzwerk ist umso besser an die Trainingsdaten angepaßt, und zeigt ein umso besseres Entscheidungsverhalten, je kleinere Werte E annimmt. Andererseits ist E eine Funktion der Einstellungen der SP-Register der Basiszellen.

Ziel des Trainingsverfahrens ist es, die SP-Register, und damit die Auswahl an möglichen Boole'schen Funktionen der Basiszellen, so einzustellen, daß E ein Minimum annimmt. Damit ist eine Optimierungsaufgabe definiert, die sich nicht in klassischer Weise geschlossen lösen läßt. Aus diesem Grunde wird zur Minimierung der Kostenfunktion E für einen vorgegebenen Satz von Trainingsdaten durch geeignete Variation der SP-Registerinhalte der Basiszellen ein stochastisches Optimierungsverfahren verwendet, das auch als simulierte Abkühlung (simulated annealing) bezeichnet wird (P.J.M. van Laarhoven and E.H.L. Aarts, "Simulated annealing: Theory and Applications", D.Reidel Publishing Comp., Dodrecht, 1987).

Zur Durchführung des Trainingsverfahrens wird eine Wahrscheinlichkeit P für die Veränderung des Registerinhalts einer Basiszelle in einem Trainingsschritt

$$(5) \qquad p(t) = \exp(-t/T)$$

definiert. Dabei ist t die Anzahl der bereits durchgeführten Trainingsschritte und T ist eine Konstante, welche die Geschwindigkeit des Lernvorgangs bestimmt. Jeder Trainingsschritt beinhaltet eine Anzahl von Trainingsdurchläufen. In einem Trainingsdurchlauf wird die Kostenfunktion E für einen Satz von Trainingsdaten und einen Satz von SP-Registerinhalten bestimmt. Im ersten Trainingsschritt werden vor jedem Trainingsdurchlauf sämtliche SP-Register stochastisch verändert, d.h. alle 12 möglichen Einstellungen des SP-Registers sind gleich wahrscheinlich. Dies geschieht vorzugsweise mit Hilfe eines Steuerrechners, der Bestandteil einer Anordnung zur Durchführung des Trainingsverfahrens ist. Dieser Steuerrechner generiert in zufälliger Weise die SP Registerinhalte und gibt diese über den SP-Bus an die Schaltungsanordnung bzw. an das ADALILNE-Netzwerk, welches mit Hilfe der Basiszellen realisiert ist, weiter. Zusätzlich werden alle SP-Registerinhalte im Steuerrechner gespeichert, für welche die Kostenfunktion E kleiner ist als alle bisher im Trainingsverlauf ermittelten Werte von E. Dieser gespeicherte Satz von SP-Registerinhalten ist also die bisher optimale gefundene Einstellung des Netzwerkes.

Die Trainingsdurchläufe für eine Wahrscheinlichkeit F werden solange fortgeführt, bis sich keine weitere Reduzierung von E mehr ergibt. Danach erfolgt der Übergang zum nächsten Trainingsschritt durch Inkrementierung der Zeitvariablen t des Lernprozesses durch den Übergang t = t + 1, und daraus ergibt sich über Gleichung (5) eine neue, verringerte Wahrscheinlichkeit P (t+1) dafür, daß die SP-Registereinstellung einer Basisschaltung verändert wird.

In dieser Weise wird der Lernprozeß solange durchgeführt, bis die Kostenfunktion E ein globales Minimum annimmt. Diese Einstellung wird nun endgültig in die SP-Register eingetragen. Das Trainingsverfahren ist damit beendet und das Netzwerk kann der Anordnung zur Durchführung des Trainingsverfahrens entnommen und seiner Anwendung zugeführt werden. Bild 12 zeigt die Gesamtanordnung zur Durchführunbg des Trainingsverfahrens zusammen mit dem zugehörigen Lernrechner und der Trainingsdatenbasis.

## Patentansprüche

1. Neuronales Netzwerk vom ADALINE Typ, dessen Eingänge Boole'sche Variable sind, realisiert durch Boole'sche Funktionen, bei dem

(a) anstelle erst Neuronen mit $2^n$ binären Eingängen, binäre Bäume aus $2^n$-2 zweiten Neuronen mit jeweils zwei Eingängen verwendet werden, wobei jedes zweite Neuron aus adaptiven linearen Kombinierern und nachgeschalteten binären Quantisierern besteht,

(b) die Gewichte derjenigen zweiten Neuronen, welche den Blättern der binären Bäume entsprechen, mit den Gewichten der ersten Neuronen übereinstimmen,

(c) die Gewichte der übrigen zweiten Neuronen auf den Zweigen der binären Bäume, denen die binären Quantisierer vorgeschaltet sind, durch die Absolutbeträge der Ausgangsgrößen der diesen Quantisierern vorgeschalteten adaptiven linearen Kombinierer gegeben sind, und bei dem

(d) sämtliche $2^n$-1 zweite Neuronen in Abhängigkeit von ihren Eingangsgewichten durch die ihnen entsprechenden Boole'schen Funktionen zweier Variabler ersetzt worden sind.

2. Neuronale Schaltungsanordnung mit einem neuronales Netzwerk nach Anspruch 1 vom ADALINE-Typ, bei der jedes zweite Neuron durch eine digitale Basisschaltung realisiert worden ist.

3. Schaltungsanordnung nach Anspruch 2,
dadurch **gekennzeichnet**,
daß die digitale Basisschaltung aus einer kombinatorischen Digitalschaltung zur Erzeugung des Satzes von Boole'schen Funktionen, welcher ein zweites Neuron für beliebige Werte seiner Eingangsgewichte ersetzt, einem dieser kombinatorischen Digitalschaltung nachgeschalteten Demultiplexer, und einem Register zur Steuerung des Demultiplexers, welches vier Eingänge zur Adressierung des Demultiplexers und einen Clock-Eingang besitzt, besteht.

4. Schaltungsanordnung nach Anspruch 3,

dadurch **gekennzeichnet,**
daß ein Adreßdecoder vorgesehen ist, mit dessen Hilfe die Clock-Eingänge aller digitalen Basisschaltungen einzeln angesteuert werden können.

5. Verfahren zum Training der Schaltungsanordnung nach den Ansprüchen 3 oder 4, bei dem die Registerinhalte der Basisschaltungen in zufälliger Weise verändert werden um eine Kostenfunktion zu minimieren.

6. Verfahren nach Anspruch 5,
dadurch **gekennzeichnet,**
daß die Wahrscheinlichkeit für eine Änderung eines Registerinhalts, die mit einer Erhöhung des Wertes der Kostenfunktion verbunden ist, mit der Zeit abnimmt.

7. Verfahren nach einem der Ansprüche 5 oder 6,
dadurch **gekennzeichnet,**
daß die Kostenfunktion die Summe der Exklusiv-Oder-Verknüpfungen der Antworten der Schaltungsanordnung mit Soll-Antworten ist.

## Claims

1. ADALINE-type neural network whose inputs are Boolean variables, realized using Boolean functions, in which
    (a) instead of first neurons with $2^n$ binary inputs, binary trees comprising $2^n-2$ second neurons with two inputs in each case are used, every second neuron comprising adaptive linear combiners and following binary quantizers,
    (b) the weighting factors of those second neurons which correspond to the leaves of the binary trees correspond to the weighting factors of the first neurons,
    (c) the weighting factors of the other second neurons on the branches of the binary trees, which are preceded by the binary quantizers, are represented by the absolute amounts of the output values of the adaptive linear combiners preceding said quantizers, and in which
    (d) all $2^n-1$ second neurons have been replaced by their corresponding Boolean functions of two variables depending on their input weighting factors.

2. Neural circuit arrangement having an ADALINE-type neural network according to Claim 1, in which each second neuron has been realized by a digital base circuit.

3. Circuit arrangement according to Claim 2, characterized in that the digital base circuit comprises a combinational digital circuit for generating the set of Boolean functions which replaces a second neuron for any values of its input weighting factors, a demultiplexer following said combinational digital circuit, and a register for controlling the demultiplexer which has four inputs for addressing the demultiplexer and a clock input.

4. Circuit arrangement according to Claim 3, characterized in that an address decoder is provided, with the aid of which the clock inputs of all the digital base circuits can be driven individually.

5. Process for training the circuit arrangement as claimed in claims 3 or 4, in which the register contents of the base circuits are altered in a random manner in order to minimize a cost function.

6. Process according to Claim 5, characterized in that the probability of an alteration of register contents, which is linked to an increase in the value of the cost function, decreases over time.

7. Process according to one of Claims 5 or 6, characterized in that the cost function is the sum of the exclusive-OR gatings of the responses of the circuit arrangement with nominal responses.

## Revendications

1. Réseau neuronique du type ADALINE, dont les entrées sont des variables booléennes, constitué de fonctions booléennes et dans lequel :

(a) au lieu de premiers neurones comportant $2^n$ entrées binaires, des arbres binaires formés de $2^n$-2 secondes neurones ayant chacun deux entrées sont utilisés, chaque second neurone étant constitué de circuits combinatoires linéaires adaptatifs et de quantificateurs binaires branchés en aval,

(b) les poids de ceux des seconds neurones, qui correspondent aux feuilles des arbres binaires, sont identiques aux poids des premiers neurones,

(c) les poids des autres seconds neurones présents dans les branches des arbres binaires, en amont desquels sont branchés des quantificateurs binaires, sont définis par les valeurs absolues des grandeurs de sortie des circuits combinatoires linéaires adaptatifs branchés en amont de ces quantificateurs,

et dans lequel

(d) tous les $2^n$-1 seconds neurones ont été remplacés, en fonction de leurs poids d'entrée, par leur fonction booléenne, à deux variables.

2.  Montage neuronique comportant un réseau neuronique suivant la revendication 1, du type ADALINE, dans lequel chaque second neurone a été formé au moyen d'un circuit numérique de base.

3.  Montage suivant la revendication 2, caractérisé par le fait que le circuit numérique de base est constitué d'un circuit numérique combinatoire servant à produire l'ensemble de fonctions booléennes, qui remplace un second neurone pour des valeurs quelconques de ses poids d'entrée, d'un démultiplexeur branché en aval de ce circuit numérique combinatoire, et d'un registre, qui est destiné à la commande du démultiplexeur et qui possède quatre entrées pour l'adressage du démultiplexeur et une entrée de signal d'horloge.

4.  Montage suivant la revendication 3, caractérisé par le fait qu'il est prévu un décodeur d'adresses, à l'aide duquel les entrées d'horloge de tous les circuits de base numérique peuvent être commandées individuellement.

5.  Procédé de mise en condition du montage suivant la revendication 3 ou 4, dans lequel on modifie les contenus des registres des circuits de base de façon aléatoire de manière à minimiser une fonction de coût.

6.  Procédé suivant la revendication 5, caractérisé par le fait que la probabilité d'une modification d'un contenu d'un registre, qui est liée à un accroissement de la valeur de la fonction de coût, diminue dans le temps.

7.  Procédé suivant l'une des revendications 5 ou 6, caractérisé par le fait que la fonction de coût est la somme des combinaisons OU-Exclusif des réponses du montage avec des réponses de consigne.

# FIG 1

# FIG 2

# FIG 3

## FIG 4

Hyperebene außerhalb
Einheitswürfel

FIG 5

FIG 6

FIG 7

FIG 8

# FIG 9

clock    switch position (SP)

S1 S2 S3    S4

SP-REGISTER

d1

d2

&

&

&

&

R

A ▷ → Ā (INVERTER)

A
B    & → y = AB (AND)

# FIG 10

# FIG 11

d1
d2
d3

dN

ADALINE
Netzwerk

(Boole'sche
Realisierung)

AN

$\widehat{R}$

EO
+

E

Soll-Antwort

R

# FIG 12

BASISZELLENADRESSEN

$[d1,d2...dN]^T$

ADALINE
Netzwerk

(Boole'sche
Realisierung)

AN

SP-BUS

$\widehat{R}$

EO
+

E

R

SPB

BA

TR

Trainingsdaten

TD

Trainingsrechner